# EUROPEAN PATENT APPLICATION

(11) **EP 4 358 154 A1**
(43) Date of publication of application: **24.04.2024**
(21) Application number: 23202845.6
(22) Date of filing: 10.10.2023
(51) Int. Cl.: H01L 31/0216, H01L 31/0224, H01L 31/068

(54) **SOLAR CELL, SOLAR CELL MODULE AND SOLAR CELL MANUFACTURING EQUIPMENT**

(30) Priority: 19.10.2022 CN 202222749586 U
(71) Applicant: Trina Solar Co., Ltd, Changzhou, Jiangsu 213031 (CN); Trina Solar (Changzhou) Science & Technology Co., Ltd, Changzhou Jiangsu 213031 (CN)
(72) Inventor: ZOU, Yang, Changzhou (Jiangsu), 213031 (CN)
(74) Representative: Cabinet Laurent & Charras

(57) **Abstract**

A solar cell includes: a semiconductor substrate (101), both a front surface and a back surface of the semiconductor substrate (101) are provided with a preset structure; the preset structure comprises: a fine grid layer including a plurality of fine grids; a dielectric protection layer formed on the fine grid layer; and a busbar layer including a plurality of busbars that penetrate through the dielectric protection layer and are connected with the fine grids. By setting an additional dielectric protection layer between the fine grid layer and the busbar layer, the resistance against damp heat aging of the solar cell or solar cell module of the present disclosure can be effectively enhanced.

## Description

### TECHNICAL FIELD

The present disclosure relates to a solar cell, a solar cell module, and solar cell manufacturing equipment.

### BACKGROUND

In the photovoltaic industry, the core technology is solar cells. The photoelectric conversion efficiency of solar cells and the power of solar cell modules are the core indicators. However, there are many technical hurdles in improving the performance of the solar cell, such as the risk of failure due to dump heat.

In practice, performance degradation tests under certain simulated temperature and humidity are carried out on solar cell modules to obtain attenuation characteristics of solar cell modules. The slower the attenuation, the stronger the heat/moisture resistance of the solar cell modules.

The moisture resistance and heat resistance of solar cell modules with N-type solar cells are affected by the fabrication processes, and at the same time, it is also largely limited by the anti-moisture and heat-resistance ability of the solar cells included therein.

It should be readily understood that both the foregoing general description and the following detailed description are exemplary and explanatory only, and are not intended as a limitation to the scope of the present disclosure.

### SUMMARY

In order to overcome the technical hurdles described, the present disclosure provides a solar cell, a solar cell module, and solar cell manufacturing equipment.

The present disclosure provides a solar cell including:
a semiconductor substrate; and
a preset structure provided on both a front surface and a back surface of the semiconductor substrate;
the preset structure includes:
   a fine grid layer including a plurality of fine grids;
   a dielectric protection layer formed on the fine grid layer; and
   a busbar layer including a plurality of busbars, wherein, the busbars penetrate through the dielectric protection layer and are connected with the fine grids.

In some embodiments of the present disclosure, the dielectric protection layer includes a passivation anti-reflection layer.

In some embodiments of the present disclosure, the dielectric protection layer is made of any one of silicon oxide, silicon nitride and silicon oxynitride.

In some embodiments of the present disclosure, a thickness of the dielectric protection layer is 1nm-10nm.

In some embodiments of the present disclosure, the busbars is formed by penetrating the dielectric protection layer through a sintering process, and they are electrically connected with the fine grids.

In some embodiments of the present disclosure, the busbars are arranged in parallel, and the fine grids are arranged in a preset pattern.

In some embodiments of the present disclosure, the fine grid layer or the busbar layer is prepared by distributed printing.

In some embodiments of the present disclosure, the semiconductor substrate is an N-type silicon wafer, and the solar cell further includes:
a p+ emitter layer formed on the front surface of the semiconductor substrate;
a first passivation anti-reflection layer formed on the p+ emitter layer;
a first preset structure formed on the first passivation anti-reflection layer, wherein the first preset structure comprises a first fine grid layer, a first dielectric protection layer and a first busbar layer; wherein the first fine grid layer comprises a plurality of first fine grids, wherein a plurality of first fine grids penetrate both the p+ emitter layer and the first passivation anti-reflection layer; wherein the first dielectric protection layer is formed on the first fine grid layer; and wherein the first busbar layer comprising a plurality of first busbars that are formed by penetrating through the first dielectric protection layer and are connected with the first fine grids;
a tunnel oxide layer formed on the back surface of the semiconductor substrate;
an n+ polysilicon layer formed on the tunnel oxide layer;
a second passivation anti-reflection layer formed on the n+ polysilicon layer; and
a second preset structure formed on the second passivation anti-reflection layer, wherein the second preset structure comprises a second fine grid layer, a second dielectric protection layer and a second busbar layer; wherein the second fine grid layer comprises a plurality of second fine grids, wherein a plurality of second fine grids penetrate through the tunnel oxide layer, the n+ polysilicon layer and the second passivation anti-reflection layer; wherein the second dielectric protection layer is formed on the second fine grid layer; and wherein the second busbar layer comprising a plurality of second busbars that are formed by penetrating through the second dielectric protection layer and are connected with the second fine grids.

The present disclosure also provides a solar cell module including the solar cell.

In some embodiments of the present disclosure, the solar cell module is a single-glass solar module or a double-glass solar module.

The present disclosure further provides solar cell manufacturing equipment for manufacturing a solar cell, wherein, the solar cell manufacturing equipment includes a processing unit for preparing the dielectric protection layer.

The present disclosure provides a solar cell, a solar cell module, and solar cell manufacturing equipment, the solar cell includes: a semiconductor substrate, both a front surface and a back surface of the semiconductor substrate are provided with a preset structure; the preset structure includes: a fine grid layer including a plurality of fine grids; a dielectric protection layer formed on the fine grid layer; and a busbar layer including a plurality of busbars, wherein the busbars penetrate through the dielectric protection layer and are connected with the fine grids. By setting an additional dielectric protection layer between the fine grid layer and the busbar layer, the resistance against damp heat aging of the solar cell or solar cell module of the present disclosure can be effectively enhanced.

### BRIEF DESCRIPTION OF THE DRAWINGS

The foregoing and other features, and advantages of the invention are apparent from the following detailed description taken in conjunction with the accompanying drawings in which:
FIG. 1 shows a schematic diagram of a vertical cross-sectional structure of a solar cell according to an embodiment of the present disclosure.
FIG. 2 shows a schematic top view of the solar cell of FIG. 1.
FIG. 3 shows a schematic cross-sectional structural view of a solar cell before printing one layer of first busbars and one layer of second busbars according to an embodiment of the present disclosure.

### DETAILED DESCRIPTION

In the following, embodiments of the present disclosure will be described in detail with reference to the figures. It should be understood that, the embodiments described hereinafter are only used for explaining the present disclosure, and should not be understood to limit the present disclosure. Besides, for describing the embodiments more clearly, the figures only show some aspects, instead of every aspect, of the present disclosure.

The "first", "second" and similar words used in the present disclosure do not denote any order, quantity or importance, but are only used to distinguish different components. "comprise", "include" and other similar words mean that the elements or objects appearing before these words, the elements or objects listed after these words, and their equivalents, but other elements or objects are not excluded. Similar words such as "connected" are not limited to physical or mechanical connections, but may include electrical connections, whether direct or indirect. "up", "down", etc. are only used to indicate the relative position relationship. When the absolute position of the described object changes, the relative position relationship may also change accordingly.

The solar cell may be a crystalline silicon cell, which is obtained by processing a semiconductor silicon wafer. There are primarily two types of crystalline silicon cell, P-type crystalline silicon cells and N-type crystalline silicon cells. The difference lies in the silicon wafers used. P-type silicon wafers are boron-doped, while N-type silicon wafers are phosphorus-doped. At present, since N-type solar cells can achieve higher photoelectric conversion efficiency, they have been replacing P-type solar cells gradually. There are primarily three types of N-type solar cells, tunnel oxide passivated contact (TOPCon), hetero-junction with intrinsic thin-layer (HJT) and interdigitated back contact (IBC).

The crystalline silicon solar cells are usually sheet-shaped, they are also called "solar cells". In addition, a single solar cell cannot be directly used as a power source. To convert solar energy into electrical energy, several solar cells need to be connected in series and packaged into a "solar cell module" through packaging materials (such as glass, EVA, TPT, frame, etc.). Single-glass solar cell modules are packaged with single-sided glass, and double-glass solar cell modules are packaged with double-sided glass.

The better the heat and moisture resistance of the element (the solar cell) of the solar cell modules, the better performance of the solar cell modules. The performance of solar cells is affected by the moisture and heat of the environment. Correspondingly, Damp heat (DH) tests are typically performed on solar cell modules to assess their various properties, such as photoelectric conversion efficiency, output power, etc. Since N-type HJT solar cells are more sensitive to moisture and heat, the anti-moisture and heat design of this type of cells is more important. The damp heat test is an accelerated and rigorous environmental aging test aimed at determining the ability of solar cell modules to withstand prolonged exposure to high moisture penetration and elevated temperatures. At present, the commonly used DH tests include DH-500h, DH-1000h, DH-1500h, etc., wherein 500h, 1000h and 1500h represent the duration of the test. The longer the duration, the longer the simulated degrade process of the solar cell module, and the higher the resistance to moisture and heat of the solar cell module is required.

Presently, for N-type single-glass/double-glass solar cell modules, there is no ideal technical solution for resisting damp heat. In particular, the damp heat-induced failure rate of N-type single-glass solar cell modules is high.

Therefore, the present disclosure provides a solar cell, a solar cell module, and solar cell manufacturing equipment. According to the embodiment of the present disclosure, the resistance against damp, heat, and aging of the solar cell or solar cell module can be effectively enhanced by setting an additional anti-moisture and heat dielectric protection layer between the fine grid layer and the busbar layer of the solar cell.

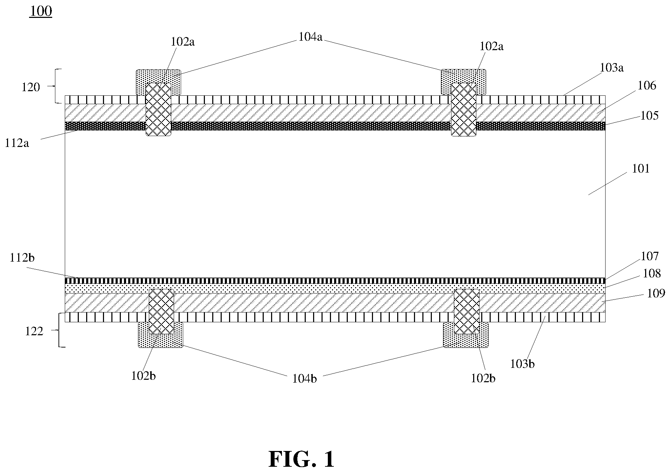

FIG. 1 shows a schematic diagram of a vertical cross-sectional structure of a solar cell 100 according to an embodiment of the present disclosure.

As shown in FIG 1, the solar cell includes a semiconductor substrate 101. In some embodiments, the semiconductor substrate 101 may be an N-type silicon wafer, such as an N-type single crystal silicon wafer. The semiconductor base 101 includes a front surface 112a and a back surface 112b. The front surface is a light-receiving side and the back surface is a backlight side.

Both the front surface 112a and the back surface 112b of the semiconductor substrate are provided with a preset structure. Exemplarily, the front surface 112a of the semiconductor substrate is provided with a first preset structure 120, and the first preset structure 120 includes a first fine grid layer, a first dielectric protection layer 104a and a first busbar layer. The back surface 112b of the semiconductor substrate is provided with a second preset structure 122, and the second preset structure includes a second fine grid layer, a second dielectric protection layer 104b and a second busbar layer.

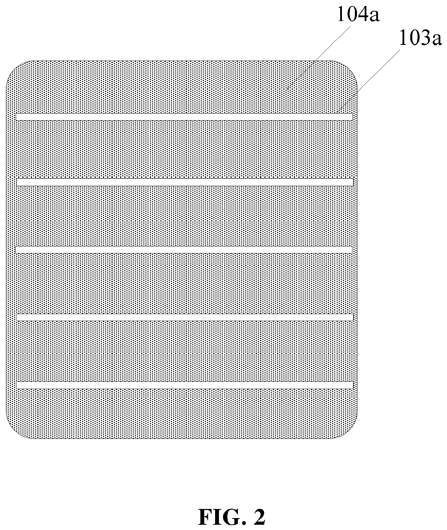

As shown in FIG. 1, the first fine grid layer includes a plurality of first fine grids 102a, and the second fine grid layer includes a plurality of second fine grids 102b. With further reference to FIG. 2, the first busbar layer includes a plurality of first busbars 103a. Similarly, the second busbar layer includes a plurality of second busbars 103b. The fine grid is also called a fine grid electrode or a fine grid line. The semiconductor substrate 101 can generate current in sunlight, and the current is collected by the fine grids; the busbars are responsible for collecting current from the fine grids and then transmitting the current.

The first fine grid layer is formed on the front surface 112a of the semiconductor substrate 101, the first dielectric protection layer 104a is formed on the first fine grid layer. The first busbar layer is formed on the first dielectric protection layer 104a. At the same time, the first busbars 103a penetrate through the first dielectric protection layer 104a and are electrically connected with the first fine grids 102a. The second fine grid layer is formed on the back surface 112b of the semiconductor substrate 101, the second dielectric protection layer 104b is formed on the second fine grid layer, and the second busbar layer is formed on the second dielectric protection layer 104b; wherein, the second busbar 103b penetrates through the second dielectric protection layer 104b and are electrically connected with the second fine grids 102b.

In some embodiments, the first fine grid layer and the second fine grid layer may be formed by printing, and the first busbar layer and the second busbar layer may also be formed by printing. The printing method may be a distributed printing (DUP), for example, multiple busbars are printed at the same time, multiple fine grids are printed at the same time. Or in other embodiments, the first fine grid layer and the second fine grid layer may be formed by processes other than printing.

In some embodiments, the first dielectric protection layer 104a and the second dielectric protection layer 104b are formed by plating (such as electroplating, chemical plating). The first dielectric protection layer 104a and the second dielectric protection layer 104b can resist damp heat, which may be made of a material for a passivation anti-reflection film. For example, for crystalline silicon solar cells, the material used for the first dielectric protection layer 104a and the second dielectric protection layer 104b may be any of the following: silicon oxide; silicon nitride; silicon oxynitride, etc., which can effectively resist heat and moisture. In some embodiments, the thickness of the first dielectric protection layer 104a and the thickness of the second dielectric protection layer 104b may both be lnm-10 nm.

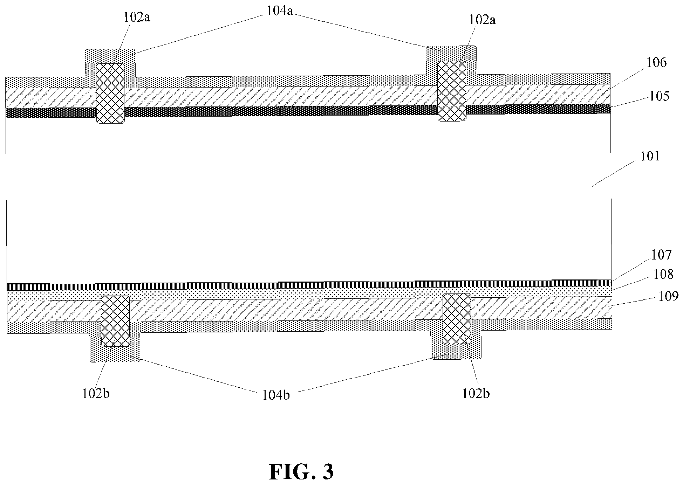

Referring FIG. 3, a solar cell before forming a preset structure are illustrated. During the processes that form the preset structure, the first fine grids 102a, the second fine grids 102b, the first busbars 103a and the second busbars 103b are in the form of metal paste before sintering, such as paste of silver and paste of other materials. FIG. 3 shows that the first dielectric protection layer 104a is disposed on the first fine grid 102a. In the process, the paste of first busbar layer 103a (not shown in FIG. 3) is disposed on the first dielectric protection layer 104a. In sintering, the paste of the first busbars 103a can burn through the first dielectric protection layer 104a made of silicon oxide/silicon nitride/silicon oxynitride, and be electrically connected with the first fine grids 102a to form the preset structure 120 as shown in FIG. 1. FIG. 3 also shows that the second dielectric protection layer 104b is disposed on second first fine grid 102b. In the process, the paste of second busbar layer 103b (not shown in FIG. 3) is disposed on the first dielectric protection layer 104b . In sintering, the paste of the second busbars 103b can burn through the second dielectric protection layer 104b and be electrically connected with the second fine grids 102b. Therefore, there should be no negative reaction between the paste of the first fine grids 102alsecond fine grids 102b and the material of the first dielectric protection layer 104alsecond dielectric protection layer 104b. Moreover, the first dielectric protection layer 104alsecond dielectric protection layer 104b does not affect the shaping of the paste of the first fine grids 102alsecond fine grids 102b because the first dielectric protection layer 104alsecond dielectric protection layer 104b only cover the paste of the first fine grids 102alsecond fine grids 102b, nor does it affect the ohmic contact and welding pull force between metal electrodes. The paste of the first busbars 103b/the second busbars 103b can burn through the first dielectric protection layer 104a/the second dielectric protection layer 104b made of silicon oxide/silicon nitride/silicon oxynitride, but will not further corrode other layers (e.g., a first passivation anti-reflection layer 106/ a second passivation anti-reflection layer 109) on the front surface 112a or the back surface 112b of the semiconductor substrate 101.

FIG. 2 shows a schematic top view of the solar cell in FIG. 1, and FIG. 3 shows a schematic diagram of the solar cell that has been plated with both the first dielectric protection layer 104a and the second dielectric protection layer 104b, but has not printed the first busbar layer and the second busbar layer yet. FIG. 1 shows a schematic diagram of the structure of FIG. 3 with printed first busbar layer and second busbar layer, wherein the first busbars 103a/the second busbars 103b burns through the first dielectric protection layer 104a / the second dielectric protection layer 104b to be electrically connected with the first fine grids 102a / the second fine grids 102b, respectively.

FIG. 2 shows a plurality of first busbars 103a on the front surface of the semiconductor substrate 101. Each first busbar 103a is surrounded by a first dielectric protection layer 104a, and the first dielectric protection layer 104a covers the first fine grid layer 102a to form protection therefor. It can be understood that the back surface of the semiconductor substrate 101 may also have the same or similar structure as above, which will not be repeated here.

In the embodiments illustrated in FIG. 2, the first busbars 103a are arranged in parallel, and the fine grids may be arranged in a preset pattern, for example, first fine grids 102a and first busbar 103a are arranged in a criss-cross pattern, or the first fine grids 102a are arranged in a hexagonal or quadrilateral pattern. Similarly, the arrangement of the second busbars 103b and the second fine grids 102b may be arranged in appropriate patterns, which will not be repeated here.

In some embodiments, additional layers may be provided between the first preset structure and the semiconductor substrate 101, or between the second preset structure and the semiconductor substrate 101.

Referring to FIG. 1 and FIG. 3, in some embodiments, the solar cell may include, on the front surface of the semiconductor substrate 101; a p+ emitter layer 105 formed on the front surface of the semiconductor substrate 101; a first passivation anti-reflection layer 106 formed on the p+ emitter layer 105. In some embodiments, the first passivation anti-reflection layer 106 may be made of silicon oxide, silicon nitride or silicon oxynitride. In some embodiments, on the first passivation anti-reflection layer 106, a first preset structure 120 is provided. The first present structure 120 includes a plurality of first fine grids 102a that penetrate through both the p+ emitter layer 105 and the first passivation anti-reflection layer 106. The first dielectric protection layer 104a is formed on the first fine grids 102a. A plurality of first busbars 103a are formed on the first passivation anti-reflection layer 106, the first busbars penetrate through the first dielectric protection layer 104a and are connected with the first fine grids 102a. The fine grids 102a are in contact with the semiconductor substrate 101.

In some embodiments, the solar cell 100 may include, on the back surface 112b of the semiconductor substrate 101, a tunnel oxide layer 107 formed on the back surface 112b of the semiconductor substrate; an n+ polysilicon layer 108 formed on a tunnel oxide layer 107; and a second passivation anti-reflection layer 109 formed on the n+ polysilicon layer 108, and the second passivation anti-reflection layer 109 may be made of silicon oxide, silicon nitride or silicon oxynitride.

In some embodiments, on the second passivation anti-reflection layer 109, a second preset structure 122 is provided. The second preset structure 122 includes a plurality of second fine grids 102b that penetrates through the second passivation anti-reflection layer 109, the tunnel oxide layer 107, and the n+ polysilicon layer 108. The second dielectric protection layer 104b is formed on the second fine grid layer 102b. A plurality of second busbars 103b is formed on the second passivation anti-reflection layer 109. The second busbars 103b penetrate through the second dielectric protection layer 104b and are connected with the second fine grids 102b. The second fine grids 102b can also be in contact with the tunnel oxide layer 108.

In some embodiments, a solar cell may be manufactured by a processes described below.

With reference to FIG. 1, manufacturing processes of a solar cell includes the following steps:
cleaning the semiconductor substrate, and texturing the front surface of the semiconductor substrate;
obtaining the diffusion square resistance of the front surface of the semiconductor substrate by boron diffusion process;
cleaning the back surface of the semiconductor substrate and then removing the p-n junction thereon;
oxidizing the back surface of the semiconductor substrate and depositing N+ polysilicon thereon;
wet cleaning semiconductor substrate;
depositing a first passivation anti-reflection layer and a second passivation anti-reflection layer respectively on the front surface and the back surface of the semiconductor substrate;
screen printing a second fine grid layer on the back surface of semiconductor substrate and drying, then plating a second dielectric protection layer on the back surface of semiconductor substrate, printing a second busbar layer on the back surface of solar cell and drying;
screen printing a first fine grid layer on the front surface of semiconductor substrate and drying, then plating a first dielectric protection layer on the front surface of semiconductor substrate, printing a first busbar layer on the front surface of solar cell and drying; and
thermally sintering the solar cell (e.g., putting the solar cell into a sintering furnace).

In addition, the manufacturing processes may also include the step of testing and sorting the sintered solar cells by using a test sorter.

By covering the fine grids with the dielectric protection layer, degradation rate of the electrical property caused by damp heat is slowed down, the damp heat resistance of the fine grids is enhanced, so that the damp heat resistance of the solar cell and especially the solar cell module including solar cells is enhanced.

The present disclosure also provides a solar cell module, which is formed by encapsulating the solar cells of FIG. 1. The solar cell module may be a single-glass solar module or a double-glass solar module.

In some embodiments, DH tests were performed on the solar cells of the embodiments according to the embodiments of the present disclosure. When the duration of the test was 6h, the battery efficiency degraded by 1%; when the duration of the test was 12h, the battery efficiency degraded by 2%; when the duration of the test was 24h, the battery efficiency degraded by 4%; when the duration of the test was 48h, the battery efficiency degraded by 8%; and when the duration of the test was 96h, the battery efficiency degraded by 12%. It can be seen that the damp heat resistance of the fine grids is excellent.

In some embodiments, DH tests were also performed separately on double-glass solar modules and single-glass solar modules.

In DH tests of the double-glass solar module, when the duration of the test was 500h, the power of the double-glass solar module degraded by 0.5%, while the electroluminescence (EL) showed no degradation; when the duration of the test was 1000h, the power of the double-glass solar module degraded by 1.0%, while the electroluminescence showed no degradation; when the duration of the test was 1500h, the power of the double-glass solar module degraded by 1.5%, while the electroluminescence showed no degradation; and when the duration of the test was 2000h, the power of the double-glass solar module degraded by 1.5%, while the electroluminescence showed no degradation. It can be seen that the damp heat resistance of the double-glass solar module is excellent.

In DH tests of the single-glass solar module, when the duration of the test was 500h, the power of the single-glass solar module degraded by 1.0%, while the electroluminescence (EL) showed no degradation; when the duration of the test was 1000h, the power of the single-glass solar module degraded by 1.5%, while the electroluminescence showed no degradation; when the duration of the test was 1500h, the power of the single-glass solar module degraded by 2.5%, while the electroluminescence showed no degradation; and when the duration of the test was 2000h, the power of the single-glass solar module degraded by 3.0 %, while the electroluminescence showed no degradation.

The present disclosure further provides solar cell manufacturing equipment, which is used to prepare the solar cells of the foregoing embodiments (such as the solar cell in FIG. 1). The solar cell manufacturing equipment includes a processing unit for preparing the dielectric protection layer. Specifically, the solar cell manufacturing equipment can be achieved by modifying the existing manufacturing equipment with additional processing unit. Further, the processing unit is a device capable of preparing or plating a dielectric protective layer, such as silicon oxide layer /silicon nitride layer /silicon oxynitride layer. Therefore, there is no need to replace existing equipment, add additional large-scale equipment, or greatly change the solar cell processes, that is, the technical solution of the present disclosure will not increase the cost significantly while improve the anti-damp/heat performance of the solar cell.

In summary, the present disclosure provides a solar cell, a solar cell module, and solar cell manufacturing equipment, the solar cell includes: a semiconductor substrate, both a front surface and a back surface of the semiconductor substrate are provided with a preset structure; the preset structure includes: a fine grid layer including a plurality of fine grids; a dielectric protection layer formed on the fine grid layer; and a busbar layer including a plurality of busbars, wherein the busbars penetrate through the dielectric protection layer and are connected with the fine grids. By setting an additional dielectric protection layer between the fine grid layer and the busbar layer, the moisture resistance and thermal resistance of the solar cell or solar cell module of the present disclosure can be effectively enhanced.

The above descriptions of the present disclosure are given in connection with some specific and preferred embodiments, other embodiments within the scope of the concept of the present disclosure are not limited to the above descriptions. Modifications and substitutions can be made without departing from the spirit and scope of the present disclosure.

## Claims

1. A solar cell comprising:
a semiconductor substrate (101) ; and
a preset structure provided on both a front surface and a back surface of the semiconductor substrate (101) are provided with a preset structure;
wherein the preset structure comprises:
a fine grid layer comprising a plurality of fine grids;
a dielectric protection layer formed on the fine grid layer; and
a busbar layer comprising a plurality of busbars, wherein, the busbars penetrate through the dielectric protection layer and are connected with the fine grids.

2. The solar cell according to claim 1, wherein the dielectric protection layer comprises a passivation anti-reflection layer.

3. The solar cell according to claim 1, wherein the dielectric protection layer is made of any one of silicon oxide, silicon nitride and silicon oxynitride.

4. The solar cell according to claim 1, wherein a thickness of the dielectric protection layer is 1nm-10nm.

5. The solar cell according to claim 1, wherein the busbars is formed by penetrating the dielectric protection layer through a sintering process, and are electrically connected with the fine grids.

6. The solar cell according to claim 1, wherein the fine grid layer or the busbar layer is prepared by distributed printing.

7. The solar cell according to claim 1, wherein the semiconductor substrate (101) is an N-type silicon wafer, and wherein the preset structure comprises a first preset structure and a second preset structure, the solar cell further comprises:
a p+ emitter layer (105) formed on a front surface of the semiconductor substrate (101);
a first passivation anti-reflection layer (106) formed on the p+ emitter layer (105), wherein the first preset structure formed on the first passivation anti-reflection layer (106), wherein the first preset structure comprises a first fine grid layer, a first dielectric protection layer (104a) and a first busbar layer; wherein the first fine grid layer comprises a plurality of first fine grids (102a), wherein a plurality of first fine grids (102a) penetrate both the p+ emitter layer (105) and the first passivation anti-reflection layer (106), wherein the first dielectric protection layer (104a) is formed on the first fine grid layer, and wherein the first busbar layer comprises a plurality of first busbars (103a) that are formed by penetrating through the first dielectric protection layer (104a) and are connected with the first fine grids (102a);
a tunnel oxide layer (108) formed on a back surface of the semiconductor substrate (101);
an n+ polysilicon layer (107) formed on the tunnel oxide layer (108); and
a second passivation anti-reflection layer (109) formed on the n+ polysilicon layer (107), wherein the second preset structure formed on the second passivation anti-reflection layer (109), wherein the second preset structure comprises a second fine grid layer, a second dielectric protection layer (104b) and a second busbar layer, wherein the second fine grid layer comprises a plurality of second fine grids (102b), wherein a plurality of second fine grids (102b) penetrate through the second passivation anti-reflection layer (109), the tunnel oxide layer (108), and the n+ polysilicon layer(107), wherein the second dielectric protection layer (104b) is formed on the second fine grid layer, and wherein the second busbar layer comprises a plurality of second busbars(103b) that are formed by penetrating through the second dielectric protection layer (104b) and are connected with the second fine grids (102b).

8. A solar cell module comprising a solar cell according to any item of claims 1-8.

9. The solar cell module according to claim 8, wherein the solar cell module is a single-glass solar module or a double-glass solar module.

10. Solar cell manufacturing equipment for manufacturing a solar cell according to any item of claims 1-8, wherein, the solar cell manufacturing equipment comprises a processing unit for preparing the dielectric protection layer.
